**Europäisches Patentamt**

**European Patent Office**

**Office européen des brevets**

(11) Veröffentlichungsnummer: **0 409 169 A2**

# EUROPÄISCHE PATENTANMELDUNG

(21) Anmeldenummer: **90113685.3**

(22) Anmeldetag: **17.07.90**

(51) Int. Cl.⁵: **G03F 7/20**

(30) Priorität: **20.07.89 CH 2710/89**

(43) Veröffentlichungstag der Anmeldung:
**23.01.91 Patentblatt 91/04**

(84) Benannte Vertragsstaaten:
**BE CH DE ES FR GB IT LI NL SE**

(71) Anmelder: **CIBA-GEIGY AG**
**Klybeckstrasse 141**
**CH-4002 Basel(CH)**

(72) Erfinder: **Losert, Ewald**
**Wartenbergstrasse 23 B**
**CH-4133 Pratteln(CH)**
Erfinder: **Honegger, Beat**
**Fröschenweg 11/4**
**CH-4127 Birsfelden(CH)**
Erfinder: **Meier, Kurt, Dr.**
**Stefanstrasse 66**
**CH-4106 Therwil(CH)**

(74) Vertreter: **Zumstein, Fritz, Dr. et al**
**Bräuhausstrasse 4**
**D-8000 München 2(DE)**

(54) **Belichtungsverfahren.**

(57) Das Verfahren zur Herstellung von photostrukturierten Schichten durch Belichtung eines positiv arbeitenden Photoresists durch ein lichtundurchlässiges, gelochtes Material erspart die aufwendige Herstellung von Filmvorlagen für Lötstopplacke.

EP 0 409 169 A2

Xerox Copy Centre

## BELICHTUNGSVERFAHREN

Die vorliegende Erfindung betrifft ein Verfahren zur Herstellung von photostrukturierten Schichten durch Belichtung eines positiv arbeitenden Resists durch ein lichtundurchlässiges, gelochtes Material.

Belichtungsverfahren von Photoresists zur Herstellung von photostrukturierten Schichten sind bekannt.

So werden von H. Steppan et al. in Angew. Chemie 94 (1982), 471-485 Bestrahlungsmasken zur Belichtung von Photoresists beschrieben, die aus Silberhalogenid-Emulsionsschichten auf Spezialgläsern bestehen. Weiter werden Polyesterfilme mit Silberschichten als Masken verwendet. Ebenfalls zum Einsatz kommen Diazofilme, durch die Photoresists belichtet werden.

Die Filmmasken verwendenden Belichtungsverfahren haben jedoch den Nachteil, dass die Masken einerseits mechanisch relativ schnell abgenutzt werden und andrerseits bei der sich während der Belichtung bildenden Wärme nicht dimensionsstabil sind. Diese Tatsache führt bei der industriellen Fertigung von Photostrukturen zu einem hohen Anteil an Ausschussware, sofern die Masken nicht nach kurzer Einsatzzeit durch neue ersetzt werden. Der Einsatz von dimensionsstabilen beschichteten Spezialglasplatten ist kostenaufwendig. Da die Bestrahlungsmasken bei jeder Aenderung auf der Leiterplatte neu hergestellt werden müssen, finden diese Glasplatten nur für spezielle Zwecke Anwendung.

Das Problem der Maskenänderung betrifft ebenfalls die Film masken.

Photoresistzusammensetzungen sind bekannt und in zahlreichen Veröffentlichungen beschrieben z.B. in De Forest, Photoresist Materials and Processes, McGraw-Hill Book Company, New York, 1975. Positiv arbeitende Photoresists sind ursprünglich in ihrem Entwickler unlösliche Gemische, werden aber nach der Belichtung durch aktivierende Strahlung geeigneter Wellenlänge in dem Entwickler löslich und definieren somit ein positives Bild.

Als positiv arbeitende Photoresists werden nur die Diazonaphthochinon-Resistsysteme technisch in grösserem Umfang eingesetzt. Diese finden nur als Aetzresists Anwendung. In der EP-A 295 211 wird eine positiv arbeitende Resistzusammensetzung beschrieben, die sich auch als Lötstopplack und Permanentresistlack eignet.

Ueberraschend wurde nun gefunden, dass sich ein lichtundurchlässiges, gelochtes Material sehr gut für diese positiv arbeitenden Photoresistzusammensetzungen als Belichtungsmasken eignet, die einerseits genügend dimensionsstabil sind und andrerseits sich einfach und kostengünstig herstellen lassen.

Die vorliegende Erfindung betrifft ein Verfahren zur Herstellung von photostrukturierten Schichten durch Belichten eines positiv arbeitenden Photoresists durch ein lichtundurchlässiges, gelochtes Material.

Als lichtundurchlässiges Material kommen z.B. eingefärbtes Papier, eingefärbter Karton, eingefärbte und beschichtete Kunststoffolie, eingefärbte Kunststoffplatte, kupferkaschiertes Basismaterial, eine Metallfolie oder ein Metallblech infrage. Diese lichtundurchlässigen Materialien sind bevorzugt.

Besonders bevorzugt sind eingefärbte Papiere und eingefärbter Karton sowie kupferkaschiertes Basismaterial.

Eine speziell bevorzugte Ausführungsform des erfindungsgemässen Verfahrens betrifft den Einsatz von eingefärbtem Papier. Dabei sind z.B. Papierstärken von 60-150 g/m$^2$ geeignet.

Eine weitere spezielle Ausführungsform des erfindungsgemässen Verfahrens betrifft den Einsatz von kupferkaschiertem Basismaterial als lichtundurchlässiges Material.

Im Prinzip ist jedoch jedes lichtundurchlässige Material geeignet, sofern es eine genügende Stabilität aufweist und sich genau lochen lässt.

Die Art der Einfärbung hängt von der Art der Bestrahlung d.h. deren Wellenlänge ab. Die Einfärbung muss so beschaffen sein, dass sie für das Licht, bei dem die Beschichtung photoempfindlich ist, undurchlässig ist.

So wird unter Farbe sowohl sichtbare wie auch UV-absorbierende Farbe verstanden.

Das lichtundurchlässige Material ist bevorzugt einerseits beim Lochen durch Stanzen oder Bohren genügend dimensionsstabil, damit es nicht verzogen wird, andrerseits darf das gelochte Material bei der Handhabung als Belichtungsmaske sich nicht verziehen. Zudem muss die Belichtungsmaske auch der Wärme dimensionsstabil widerstehen, die während der Belichtung auftritt. Es handelt sich dabei um Temperaturen bis zu ca. 70°C, jedoch nur kurzfristig d.h. für ca. 1-120 Sekunden. Während dieser Zeit darf die lichtundurchlässige gelochte Belichtungsmaske nicht schrumpfen, sich wellen oder dehnen.

Daher beträgt die Dicke des lichtundurchlässigen, gelochten Materials zweckmässig 0,01-5 mm, bevorzugt 0,1-3 mm, wobei dem Fachmann geläufig ist, welches Material bei welcher Dicke genügend dimensionsstabil ist.

Der Einsatz des lichtundurchlässigen, gelochten Materials erfolgt bevorzugt als Belichtungsmaske für Lötstopp-Photoresists oder permanente Photoresists. Die Masken decken die Oberfläche einer Leiterplatte an den Stellen ab, wo nicht gelötet oder metallisch verstärkt werden soll. Die Lötung selbst wird an den durchkontaktierten Bohrungen in der Leiterplatte vorgenommen.

Daher ist es wichtig, dass auf der Seite der Leiterplatte, auf der gelötet wird, die Lötung in Kontakt mit den Leiterbahnen der gedruckten Schaltung kommt. Zu diesem Zweck wird darauf geachtet, dass rund um die Bohrungen in der Leiterplatte der Lötstopplack entfernt ist.

Beim erfindungsgemässen Belichtungsverfahren wird dies dadurch erreicht, dass die Löcher im lichtundurchlässigen, gelochten Material einen grösseren Durchmesser aufweisen als die Löcher in der zu belichtenden Platte.

Die Lochung des lichtundurchlässigen, gelochten Materials erfolgt bevorzugt in der gleichen Apparatur, worin auch die Bohrungen der Leiterplatte, auch die der Positionierlöcher, erfolgen, jedoch mit Bohrwerkzeugen eines grösseren Durchmessers.

Durch diese Herstellungsweise ist auch die Positionierung und Justierung der fertigen Belichtungsmasken im Belichtungsverfahren vereinfacht. Zusätzlich können mehrere Belichtungsmasken in einem Arbeitsgang hergestellt werden, was in Bezug auf die Genauigkeit beim Ersatz von verbrauchten Masken von grossem Vorteil ist und auch die Herstellungskosten senkt.

Wird nun durch die grösseren Löcher in der Maske der positiv arbeitenden Photoresist auf der Leiterplattenoberfläche rund um die Bohrungen belichtet und danach entwickelt, so werden frei entwickelte Lötaugen erhalten.

Als positiv arbeitende Photoresists eignen sich vor allem Photoresistzusammensetzungen, die wärmebeständig sind.

Die Wärmebeständigkeit muss so gross sein, dass die nach der Belichtung und Entwicklung gehärtete Resistschicht der Temperatur der flüssigen Lötlegierung widersteht. Im allgemeinen handelt es sich dabei um Temperaturen von ≤ 270° C. Die Dauer des Kontakts mit der flüssigen Lötlegierung beträgt in der Regel einige Sekunden. Für die Lötung können die dem Fachmann geläufigen Verfahren, wie z.B. Eintauchen in die Lötlegierung oder durch wellenförmiges Löten (wave soldering), eingesetzt werden.

Besonders geeignete wärmebeständige positiv arbeitende Photoresistzusammensetzungen sind solche auf Epoxidharzbasis. Ganz speziell geeignet sind Photoresists, die ein thermisch härtbares Epoxidharz, einen latenten Harnstoff- oder Imidazol-Härter für das Epoxidharz und einen Eisen-aren-Komplex enthalten.

Solche Systeme sind in der EP-A 295 211 beschrieben und eignen sich insbesondere für das erfindungsgemässe Verfahren.

Die positiv arbeitenden Photoresists können auf verschiedene Weisen auf die Leiter- bzw. Trägerplatte aufgetragen werden wie z.B. durch elektrostatische Beschichtung, durch Vorhangguss, durch einen Rakel, durch leeren Siebdruck oder durch andere dem Fachmann geläufige Techniken.

Ebenfalls möglich ist es, den Photoresist auf einen temporären Träger, wie z.B. eine Polyesterfolie, aufzubringen und in getrocknetem, festem Zustand mit Hilfe eines Laminators bei erhöhter Temperatur auf eine vorgewärmte Leiterplatte zu übertragen.

Die Belichtung erfolgt mit Strahlungsquellen, für deren Strahlung die eingesetzten positiv arbeitenden Photoresists empfindlich sind. Die Wellenlänge reicht in der Regel von 200 nm bis ca. 600 nm. Es kann jedoch auch mit Strahlung kürzerer Wellenlänge d.h. unter 100 nm belichtet werden, wie z.B. mit Elektronenstrahlen.

Als Strahlungsquellen kommt daher eine grosse Anzahl der verschiedensten Typen zur Anwendung. Es sind sowohl Punktlichtquellen als auch flächenförmige Strahler (Lampenteppiche) geeignet. Beispiele sind: Kohlelichtbogenlampen, Xenonlichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen und photographische Flutlichtlampen. Der Abstand zwischen Lampen und erfindungsgemässem lichtundurchsichtigem, gelochtem Material kann je nach Anwendungszweck und Lampentyp variieren, z.B. zwischen 2 cm und 150 cm. Apparaturen für die Bestrahlung mit Elektronenstrahlen im technischen Massstab sind dem Fachmann bekannt und im Handel erhältlich.

Bei der Belichtung ist die Belichtungsmaske aus dem lichtundurchlässigen, gelochten Material in direktem Kontakt mit der positiv arbeitenden Photoresistschicht.

Die Belichtung erfolgt in der Regel von der Photoresistschichtseite her. Bei Verwendung einer entsprechend gelochten Leiter- bzw. Trägerplatte kann die Belichtung jedoch auch so erfolgen, dass diese gelochte Leiter- bzw. Trägerplatte des Photoresists selbst als lichtundurchlässiges gelochtes Material dient, wobei die Löcher keinen grösseren Durchmesser aufweisen, und diese Platte dabei mit der Photoresistschicht auf oder in einem definiertem Abstand bis zu 1 mm zu einer reflektierenden Unterlage liegt, wobei die Belichtung von der der Resistschicht abgewandten Seite der Trägerplatte her erfolgt.

Als reflektierende Unterlage dienen z.B. Metallfolien, Spiegel oder andere stark glänzende Materialien. Bevorzugt werden glänzende Metallfolien, insbesondere Aluminiumfolie.

Die Härtung des unbelichteten Photoresists und die Entwicklung der belichteten Teile des Photoresists wird nach den auf diesem Gebiet üblichen Methoden wie z.B. nach der in der EP-A 295 211 beschriebenen Weise durchgeführt.

Insbesondere sind dort Beispiele für in Frage kommende Entwickler sowie eventuelle zusätzliche Komponenten für die geeigneten positiv arbeitenden Photoresistzusammensetzungen angegeben.

Mögliches Einsatzgebiet für das erfindungsgemässe Belichtungsverfahren ist die Belichtung von Lötstopplacken oder anderer positiv arbeitender Photoresists, bei denen eine runde Belichtungsstelle erforderlich ist (z.B. Siebdruckformen, Aetzresists).

Das erfindungsgemässe Verfahren weist den Vorteil auf, dass die zeit- und kostenaufwendige Herstellung der auf diesem Gebiet sonst üblichen Filmvorlagen entfällt und dabei einfache Belichtungsapparate eingesetzt werden können.

Die nachfolgenden Beispiele erläutern die Erfindung näher.

Beispiel 1: Eine Mischung aus 12 g eines technischen Epoxidkresolnovolaks (Epoxidgehalt 4,5 Aeq./kg), 5 g eines technischen Bisphenol-A-Epoxidharzes (Epoxidgehalt 0,5 Aeq./kg), 2 g Talk, 0,06 g Irgalith®-Grün-Pigment, 0,2 g ($\eta^6$-Stilben) ($\eta^5$-cyclopentadienyl)-eisen(II)-tosylat, 0,05 g 2-Ethyl-4-methyl-imidazol, 17,5 g 3-Ethoxy-propionsäure-ethylester, 1,5g $\gamma$-Butyrolacton und 2,3 g 1-Methoxy-2-propanol wird mit einer elektrostatischen Sprühanlage (Spannung: 80 kV beim Abstand 0,18 m; Drehzahl der Sprühglocke: 500 U/Sekunde) auf eine durchkontaktierte Leiterplatte beidseitig aufgetragen und anschliessend im Umlufttrockenschrank bei 80 °C während 30 Minuten getrocknet.

Dabei wird eine Beschichtung von ca. 30 $\mu$m erhalten.

Zur Belichtung der beschichteten Leiterplatte wird ein entsprechend den Lötaugen gelochtes schwarzes Papier (Gewicht 80 g/m²) auf der Leiterplatte positioniert.

Als Lichtquelle zur Belichtung dient eine 5000 W-Quecksilberhochdrucklampe im Abstand von 50 cm zur Platte, während die Belichtungszeit 45 Sekunden beträgt. Anschliessend wird die belichtete Leiterplatte während 30 Minuten bei 135 °C im Umlufttrockenschrank gelagert und nach Abkühlen auf Raumtemperatur mit $\gamma$-Butyrolacton entwickelt.

Es resultiert eine Leiterplatte mit frei entwickelten Lötaugen. Die mit einem Flussmittel beschichtete Platte wird danach während 10 Sekunden in ein 270 °C heisses Lötbad (Blei-Zinn) getaucht und anschliessend inspiziert. Es wird keine Veränderung der Beschichtung festgestellt.

Beispiel 2: Eine gemäss Beispiel 1 beschichtete und getrocknete Leiterplatte wird nach Auflegen eines entsprechend den Lötaugen gebohrten kupferkaschierten Basismaterials während 45 Sekunden in der in Beispiel 1 beschriebenen Apparatur belichtet.

Nach thermischer Behandlung und Entwicklung gemäss Beispiel 1 wird eine Leiterplatte mit beschichtungsfreien Lötaugen erhalten. Nach dem Löttest (wie in Beispiel 1 beschrieben) wird keine Veränderung der Beschichtung festgestellt.

Beispiel 3: Beispiel 2 wird wiederholt mit der Aenderung, dass anstelle der in Beispiel 1 beschriebenen Belichtungsapparatur ein Durchlaufbelichtungsgerät (Durchlaufgeschwindigkeit 0,6 m/Minute; elektrodenfreie Quecksilberhochdrucklampe: Energie 550 mJ/cm²) verwendet wird. Es wird das gleiche Resultat wie in Beispiel 2 erhalten.

Beispiel 4: Die in Beispiel 1 beschriebene Mischung wird mit einem 100 $\mu$m Drahtrakel auf eine Polyesterfolie aufgebracht und der vorerst nasse Film bei 80 °C getrocknet. Der feste Resistfilm wird mit Hilfe eines Laminators bei 110 °C auf eine vorgewärmte Leiterplatte übertragen und nach Abkühlen auf die in Beispiel 1 beschriebene Weise belichtet, thermisch behandelt, entwickelt und gelötet. Es wird ein dem Beispiel 1 entsprechendes Resultat erzielt.

Beispiel 5: Die Photopolymerlösung aus Beispiel 1 wird mit einem 100 $\mu$m Drahtrakel zuerst auf die eine Seite einer zweiseitig kupferkaschierten Leiterplatte mit Durchverkupferung aufgebracht und der vorerst nasse Film bei 80 °C getrocknet. Die Leiterplatte wird anschliessend auf eine glänzende Aluminiumfolie aufgelegt (beschichtete Seite in Kontakt mit der Aluminiumfolie) und von der Rückseite während 30 Sekunden in der in Beispiel 1 beschriebenen Belichtungsapparatur belichtet. Nach Härtung und Entwicklung gemäss Beispiel 3 erhält man eine Leiterplatte mit von Resist freien durchkontaktierten Bohrungen, wobei zusätzlich um die Löcher ein ca. 0,2 mm breiter resistfreier Rand entsteht.

Die noch freie Seite der Leiterplatte wird ebenfalls beschichtet, getrocknet, 30 Sekunden wie oben beschrieben, belichtet, gehärtet und entwickelt und damit eine zweiseitige Resistbeschichtung auf der Leiterplatte erhalten. Die Leiterplatte wird mit aktiven und passiven Bauteilen bestückt und von der Rückseite verlötet.

## Ansprüche

1. Verfahren zur Herstellung von photostrukturierten Schichten durch Belichtung eines positiv arbeitenden Photoresists durch ein lichtundurchlässiges, gelochtes Material.

2. Verfahren gemäss Anspruch 1, worin das lichtundurchlässige, gelochte Material ein eingefärbtes Papier, ein eingefärbter Karton, eine eingefärbte und beschichtete Kunststoffolie oder -platte, ein

4

kupferkaschiertes Basismaterial, eine Metallfolie oder ein Metallblech ist.

3. Verfahren gemäss Anspruch 1, worin das lichtundurchlässige, gelochte Material dimensionsstabil ist.

4. Verfahren gemäss Anspruch 1, worin die Dicke des lichtundurchlässigen, gelochten Materials 0,01-5 mm beträgt.

5. Verfahren gemäss Anspruch 1, worin die Löcher im lichtundurchlässigen, gelochten Material einen grösseren Durchmesser aufweisen als die Löcher in der zu belichtenden Platte.

6. Verfahren gemäss Anspruch 1, worin der positiv arbeitende Photoresist ein Lötstopp-Photoresist oder ein permanenter Photoresist ist.

7. Verfahren gemäss Anspruch 1, worin der positiv arbeitende Photoresist wärmebeständig ist.

8. Verfahren gemäss Anspruch 7, worin der positiv arbeitende Photoresist bei einer Temperatur von $\leq 270^\circ$ C beständig ist.

9. Verfahren gemäss Anspruch 1, worin der positiv arbeitende Photoresist ein Resist auf Epoxidharzbasis ist.

10. Verfahren gemäss Anspruch 9, worin der positiv arbeitende Photoresist ein thermisch härtbares Epoxidharz, einen latenten Harnstoff- oder Imidazol-Härter für das Epoxidharz und einen Eisen-aren-Komplex enthält.

11. Verfahren gemäss Anspruch 1, worin der Photoresist durch elektrostatische Beschichtung, Vorhangguss, einen Rakel oder durch leeren Siebdruck auf die Trägerplatte aufgebracht wird.

12. Verfahren gemäss Anspruch 1, worin die Belichtung von der Photoresistschichtseite her erfolgt.

13. Verfahren gemäss Anspruch 1, worin eine gelochte Leiter-bzw. Trägerplatte des positiv arbeitenden Photoresists als lichtundurchlässiges, gelochtes Material dient, wobei die Löcher keinen grösseren Durchmesser aufweisen, und diese Platte mit der Resistschicht auf oder in einem definierten Abstand bis zu 1mm zu einer reflektierenden Unterlage liegt, wobei die Belichtung von der der Resistschicht abgewandten Seite der Trägerplatte her erfolgt.

14. Verfahren gemäss Anspruch 13, worin die reflektierende Unterlage eine glänzende Metallfolie ist.